# EUROPEAN PATENT SPECIFICATION

(11) **EP 2 915 193 B1**
(45) Date of publication and mention of the grant of the patent: **17.03.2021**
(21) Application number: 13789031.5
(22) Date of filing: 29.10.2013
(51) Int. Cl.: H01L 31/0216, C03C 17/36, H01L 31/0224

(54) **SILVER BASED TRANSPARENT ELECTRODE**
TRANSPARENTE ELEKTRODE AUF SILBERBASIS
ÉLECTRODE TRANSPARENTE À BASE D'ARGENT

(30) Priority: 30.10.2012 GB 201219499
(43) Date of publication of application: 09.09.2015
(73) Proprietor: Pilkington Group Limited, Nr. Ormskirk Lancashire L40 5UF (GB)
(72) Inventor: MCSPORRAN, Neil, Nr. Ormskirk Lancashire L40 5UF (US); NICHOL, Gary Robert, Warrington Cheshire WA3 4NQ (GB)
(74) Representative: Teasdale, Nicola Joanne
(86) International application number: PCT/GB2013/052815
(87) International publication number: WO 2014/068297

(56) References cited:
- WO-A1-2012/007737
- WO-A1-2012/110823
- WO-A1-2012/143704
- US-A1- 2012 048 364

## Description

The invention is concerned with transparent electrodes suitable for application in (for example) devices such as photovoltaic cells.

The use of photovoltaic cells for the generation of electrical energy is well known. The cells contain semiconductor materials exhibiting the photovoltaic effect and these are typically realised in solar panels comprising an array of cells. Solar energy represents a clean, environmentally friendly source of electricity. Of the thin film photovoltaic technologies in mass production at this time, CuIn₁₋ₓGaₓSe_{2-y}Sy (CIGS) and CuInS₂ (CIS) have demonstrated the highest efficiencies.

Photovoltaic cells are typically manufactured by deposition of successive layers of material on a transparent substrate (typically glass). These include the semiconductor referred to above, and a set of electrodes which are arranged to capture electric current generated by the semiconductor. Since the semiconductor layers are located between the electrodes, at least one of the electrodes must be transparent so that light may pass therethrough and reach the semiconductor region of the assembly. This structure is typically achieved by first depositing a transparent electrode on a glass substrate followed by further layers to provide buffer layers, interface layers etc and the semiconductor region. The transparent electrode is typically realised as a 'stack' of deposited layers.

During operation, the glass substrate provides the foremost surface of the device i.e. the surface which faces the light source. Thus, light can pass through the glass and the transparent electrode in order to reach the semiconductor region.

Sputter deposition is a Physical Vapour Deposition (PVD) technique frequently employed in the manufacture of photovoltaic devices. By non-reactive sputtering, a "target" comprising the material to be deposited, and a substrate (e.g. glass) are located in a sputtering chamber and an inert gas such as Argon is used to bombard the target. This action causes atoms and, or ions of the target material to be released which are then deposited on the substrate.

In reactive sputtering, the deposition material is formed by a chemical reaction between the target material and one or more additional reactants introduced as a gas to the sputtering chamber. Oxide and nitride films are frequently deposited by reactive sputtering.

According to current thinking, a number of qualities are desirable in the transparent electrode. In addition to the requisite low sheet resistance and high transparency, a suitable 'growth' layer should be provided, which lends itself to deposition of subsequent layers thereon.

For CdTe devices in particular, a growth layer having a smooth morphology offers improved growth of the subsequent CdS layer and reduced electrical shorting in the device due to 'pinholes'. ('Pinholes' are small holes in the CdS layer associated with high points in a rough underlayer).

Moreover the manufacturing process involves subjecting the device to high temperatures after deposition of the transparent conducting electrode so an electrode design that is able to withstand such temperatures is desirable.

Applicant's co-pending application GB1102724.0 describes heat treatable, silver based coating stacks designed for use in low emissivity (low-E) or solar control glazings. These stacks comprise a lower anti-reflection layer; a silver-based functional layer; a barrier layer and an upper anti-reflection layer. The lower anti-reflection layer comprises a base layer based on an (oxi)nitride of silicon and/or an (oxi)nitride of aluminium; a layer based on an oxide of Zn and Sn; a separation layer based on a metal oxide and/or an (oxi)nitride of silicon and a top layer based on an oxide of Zn.

The coated glass pane disclosed by GB1102724.0 provides good heat treatability, without the need for a NiCrOₓ sacrificial barrier layer above the silver-based functional layer.

The lower dielectric (lower anti-reflection layer and separation layer) provides good stability at elevated temperatures, protecting the silver layer, and also offers good (i.e. low) sheet resistance. The barrier layer offers physical robustness and good sheet resistance. The upper dielectric layer, however, offers electrical properties that are unsuitable for an electrical device hence the coating stack disclosed in GB1102724.0 is unsuitable for use as a transparent conducting electrode.

FR2919114 discloses a cadmium based photovoltaic cell wherein the transparent electrode has a metallic functional layer in combination with various antireflection layers in a specific arrangement. The publication includes transparent electrode stacks having aluminium doped zinc oxide as the top coating of the upper dielectric layer and teaches that this coating should have a resistivity of 0.35-2.5x10-3 Ω.cm.

WO 2012/110823 A1 discloses a coated glass pane comprising the following layers in sequence: glass substrate; a lower anti-reflection layer; a silver-based functional layer, the lower anti-reflection layer comprising in sequence from the glass substrate a layer based on an oxide of Zn and Sn and/or an oxide of Sn, a separation layer based on a metal oxide and/or an (oxi)nitride of silicon and/or an (oxi)nitride of aluminium and a top layer based on an oxide of Zn. The aim of the disclosure is to provide a coated glass pane with a neutral reflection colour after toughening.

WO 2012/143704 A1 also discloses a coated glass pane comprising the following layers in sequence: a glass substrate; a lower anti-reflection layer; a silver-based functional layer; a barrier layer; and an upper anti-reflection layer. The barrier layer comprises at least three partial barrier layers in sequence from the silver-based functional layer in the form of a lower partial barrier layer, a central partial barrier layer and an upper partial barrier layer, wherein the central partial barrier layer has a different composition to both the lower partial barrier layer and the upper partial barrier layer. However, neither WO 2012/143704A1 or WO 2012/110823 A1 are directed to transparent electrodes for photovoltaic cells.

In contrast, US 2012/048364 A1 discloses a photovoltaic panel, comprising an absorbent photovoltaic material, and a front side substrate wherein the front side substrate comprises, on a main surface, a transparent electrode coating comprising a stack of thin layers comprising at least one metal functional layer, and at least a first and second antireflection coating. The antireflection coatings each comprise at least one antireflection layer and the at least one metal functional layer is placed between the first and second antireflection coatings. In addition, the antireflection coating is placed above the metal functional layer opposite the substrate, and comprises a single antireflection layer. However, the disclosure does not address how to provide a toughenable electrode that acts as a suitable growth layer for the deposition of subsequent layers.

The coating stack featured in the present invention comprises a combination of layers which offers the requisite optical transparency, low sheet resistance, physical robustness and stability at elevated temperatures

According to the invention, a transparent electrode for a photovoltaic cell comprises the features recited in claim 1 attached hereto.

The electrode comprises a second dielectric layer which in turn comprises an additional layer of ZnO:Al. Preferably the ZnO:Al layer is in direct contact with the barrier layer although a further layer of ZnSnOₓ may be included and this layer may be located between the ZnO:Al layer and the barrier layer.

In the following discussion of the invention, unless stated to the contrary, the disclosure of alternative values for the upper or lower limit of the permitted range of a parameter, coupled with an indication that one of said values is more highly preferred than the other, is to be construed as an implied statement that each intermediate value of said parameter, lying between the more preferred and the less preferred of said alternatives, is itself preferred to said less preferred value and also to each value lying between said less preferred value and said intermediate value.

In the context of the present invention, where a layer is said to be "based on" a particular material or materials, this means that the layer predominantly consists of the corresponding said material or materials, which means typically that it comprises at least about 50 at.% of said material or materials.

The base layer based on an (oxi)nitride of silicon and/or an (oxi)nitride of aluminium may have a thickness of at least 5 nm, preferably from 5 to 60 nm, more preferably from 10 to 50 nm, even more preferably from 20 to 40 nm, most preferably from 25 to 35 nm. This base layer serves as a glass side diffusion barrier amongst other uses.

The term "(oxi)nitride of silicon" encompasses both Si nitride (SiNₓ) and Si oxinitride (SiOₓN_{y}) whilst the term "(oxi)nitride of aluminium" encompasses both Al nitride (AlNₓ) and Al oxinitride (AlOₓN_{y}). Si nitride, Si oxinitride, Al nitride and Al oxinitride layers are preferably essentially stoichiometric (e.g. Si nitride = Si₃N₄, x = 1.33) but may also be substoichiometric or even super-stoichiometric, as long as the heat treatability of the coating is not negatively affected thereby. One preferred composition of the base layer based on an (oxi)nitride of silicon and/or an (oxi)nitride of aluminium is an essentially stoichiometric mixed nitride Si₉₀Al₁₀Nₓ.

Layers of an (oxi)nitride of silicon and/or an (oxi)nitride of aluminium may be reactively sputtered from Si- and/or Al-based targets respectively in a sputtering atmosphere containing nitrogen and argon. An oxygen content of the base layer based on an (oxi)nitride of silicon and/or an (oxi)nitride of aluminium may result from residual oxygen in the sputtering atmosphere or from a controlled content of added oxygen in said atmosphere. It is generally preferred if the oxygen content of the silicon (oxi)nitride and/or aluminium (oxi)nitride is significantly lower than its nitrogen content, i.e. if the atomic ratio O/N in the layer is kept significantly below 1. It is most preferred to use Si nitride and/or aluminium nitride with negligible oxygen content for the base layer of the lower anti-reflection layer. This feature may be controlled by making sure that the refractive index of the layer does not differ significantly from the refractive index of an oxygen-free Si nitride and/or aluminium nitride layer.

It is within the scope of the invention to use mixed Si and/or Al targets or to otherwise add metals or semiconductors to the Si and/or Al component of this layer as long as the essential barrier and protection property of the base layer of the lower anti-reflection layer is not lost. It is well known and established to mix Al with Si targets, other mixed targets not being excluded. Additional components may be typically present in amounts of up to about 10 - 15 wt.%. Al is usually present in mixed Si targets in an amount of about 10 wt.%.

The layer based on an oxide of Zn and Sn of the lower anti-reflection layer serves to improve stability during a heat treatment by providing a dense and thermally stable layer and contributing to reduce the haze after a heat treatment. The layer based on an oxide of Zn and Sn of the lower anti-reflection layer may have a thickness of at least 0.5 nm, preferably from 0.5 to 10 nm, more preferably from 0.5 to 9 nm, even more preferably from 1 to 8 nm, even more preferably from 1 to 7 nm, even more preferably from 2 to 6 nm, even more preferably from 3 to 6 nm, most preferably from 3 to 5 nm. An upper thickness limit of about 8 nm is preferred due to optical interference conditions and by a reduction of heat treatability due to the resulting reduction in the thickness of the base layer that would be needed to maintain the optical interference boundary conditions for anti-reflecting the functional layer.

The layer based on an oxide of Zn and Sn of the lower anti-reflection layer is preferably located directly on the base layer based on an (oxi)nitride of silicon and/or an (oxi)nitride of aluminium.

The layer based on an oxide of Zn and Sn (abbreviation: ZnSnOₓ) of the lower anti-reflection layer preferably comprises about 10 - 90 wt.% Zn and 90 - 10 wt.% Sn, more preferably about 40 - 60 wt.% Zn and about 40 - 60 wt.% Sn, preferably about 50 wt.% each of Zn and Sn, in wt.% of its total metal content. The layer based on an oxide of Zn and Sn may be deposited by reactive sputtering of a mixed ZnSn target in the presence of O₂.

The separation layer based on a metal oxide and/or an (oxi)nitride of silicon may have a thickness of at least 0.5 nm, preferably from 0.5 to 6 nm, more preferably from 0.5 to 5 nm, even more preferably from 0.5 to 4 nm, most preferably from 0.5 to 3 nm. These preferred thicknesses enable further improvement in haze upon heat treatment. The separation layer provides protection during the deposition process and during a subsequent heat treatment. The separation layer is either essentially fully oxidised immediately after its deposition, or it oxidizes to an essentially fully oxidized layer during deposition of a subsequent oxide layer.

The separation layer may be deposited using non-reactive sputtering from a ceramic target based on for instance a slightly substoichiometric titanium oxide, for example a TiO_{1.98} target, as an essentially stoichiometric or as a slightly substoichiometric oxide, by reactive sputtering of a target based on Ti in the presence of O₂, or by depositing a thin layer based on Ti which is then oxidised. In the context of the present invention, an "essentially stoichiometric oxide" means an oxide that is at least 95% but at most 105% stoichiometric, whilst a "slightly substoichiometric oxide" means an oxide that is at least 95% but less than 100% stoichiometric.

When the separation layer is based on a metal oxide said separation layer may comprise a layer based on an oxide of Ti, NiCr, InSn, Zr, Al and/or Si.

The separation layer may further include one or more other chemical elements chosen from at least one of the following elements Ti, V, Mn, Co, Cu, Zn, Zr, Hf, Al, Nb, Ni, Cr, Mo, Ta, or from an alloy based on at least one of these materials, used for instance as dopants or alloyants.

The top layer based on an oxide of Zn primarily functions as a growth promoting layer for any subsequently deposited silver-based functional layer. It is preferred that this layer comprises an oxide of Zn, optionally mixed with metals such as Al or Sn in an amount of up to about 10 wt.% (wt.% referring to the target metal content). A typical content of said metals such as Al or Sn is about 2 wt.%, Al being actually preferred. ZnO and mixed Zn oxides have proven very effective as a growth promoting layer that assists in achieving a low sheet resistance at a given thickness of the subsequently deposited silver-based functional layer. It is preferred if the top layer of the lower anti-reflection layer is reactively sputtered from a Zn target in the presence of O₂ or if it is deposited by sputtering a ceramic target, e.g. based on ZnO:Al, in an atmosphere containing no or only a low amount, generally no more than about 5 vol. %, of oxygen. The top layer based on an oxide of Zn may have a thickness of at least 2 nm, preferably from 2 to 15 nm, more preferably from 3 to 12 nm, even more preferably from 4 to 10 nm, even more preferably from 5 to 8 nm.

The silver-based functional layer(s) may consist essentially of silver without any additive, as is normally the case in the area of low-e and/or solar control coatings. It is, however, within the scope of the invention to modify the properties of the silver-based functional layer(s) by adding doping agents, alloy additives or the like or even adding very thin metal or metal compound layers, as long as the properties of the silver-based functional layer(s) necessary for its (their) function as highly light-transmitting and low lightabsorbent IR-reflective layer(s) are not substantially impaired thereby.

The thickness of a silver-based functional layer is dominated by its technical purpose. For typical low-e and/or solar control purposes the preferred layer thickness for a single silver-based layer is from 5 to 20 nm, more preferably from 5 to 15 nm, even more preferably from 5 to 13 nm, even more preferably from 8 to 12 nm, most preferably from 10 to 11 nm. With such a layer thickness light transmittance values of above 86 % and a normal emissivity below 0.05 after a heat treatment can be easily achieved for single silver coatings. If better solar control properties are aimed at the thickness of the silver-based functional layer may be adequately increased or several spaced functional layers may be provided as further explained below.

Preferably the top layer based on an oxide of Zn in the lower anti-reflection layer is in direct contact with the silver-based functional layer. Preferably the layers between the glass substrate and the silver-based functional layer consist of the four layers of the lower anti-reflection layer listed above.

The barrier layer may comprise one or more layers based on a metal oxide, such as ZnO:Al. The barrier layer may have a total thickness of from 0.5 to 20 nm, preferably from 1 to 10 nm, more preferably from 1 to 8 nm, even more preferably from 1 to 7 nm, most preferably from 2 to 6 nm. Such barrier layer thicknesses enable ease of deposition. It has been found that a superior protection of the silver-based functional layer during the deposition process and a high optical stability during a heat treatment can be achieved if the barrier layer comprises a layer of a mixed metal oxide sputtered from a mixed metal oxide target.

As the photovoltaic cell is intended to undergo only a minimum colour (and light transmittance) modification during a heat treatment, a barrier layer comprising essentially stoichiometric metal oxides is preferred. The use of a barrier layer based on a metal oxide rather than a metallic or largely suboxidic barrier layer leads to an extremely high optical stability of the coating during a heat treatment and effectively assists in keeping optical modifications during a heat treatment small.

At least a portion of the barrier layer that is in direct contact with the silver-based functional layer is preferably deposited using non-reactive sputtering of an oxidic target to avoid silver damage.

The invention will now be described by reference to the following non-limiting examples.

Silver based coating stacks on glass substrates according to the invention were prepared by sputter deposition. Table 1 shows the resulting stack structures along with various measured properties of each sample and a sample of NSG **TEC**™ C15 with a sputtered 25nm ZnO:Al layer included for comparison.

ZnO:Al represents a reactively sputtered mixture of zinc and aluminium oxides, predominantly the former, produced using an zinc/aluminium target in an oxygen/argon atmosphere. ZAO represents a non-reactively sputtered mixture of zinc and aluminium oxides, predominantly the former, obtained using a proprietary target comprising these oxides.

**Table 1**

| | **NSG TEC™ C15/ZnO:Al (25nm)** | **Example 1** | **Example 2** | **Example 3** (not according to invention) |
|---|---|---|---|---|
| | SnO₂ (25) | SiₓN_{y} (26) | SiₓN_{y} (27) | SiₓN_{y} (30) |
| | SiO₂ (25) | ZnSnOₓ (5) | ZnSnOₓ (5) | ZnSnOₓ (5) |
| | SnO₂:F (340) | TiO₂ (2.5) | TiO₂ (2.5) | TiO₂ (2.5) |
| | ZnO:Al (25) | ZnO:Al (5) | ZnO:Al (5) | ZnO:Al (5) |
| | | Ag (10) | Ag (10) | Ag (10) |
| | | ZAO (2) | ZAO (2) | ZAO (<5) |
| | | ZnSnOₓ (2) | ZnSnOₓ (2) | ZnSnOₓ (<5) |
| | | ZAO (3) | ZAO (3) | ZAO (44) |
| | | ZnO:Al (40) | ZnSnOₓ (26) | |
| | | | ZnO:Al (10) | |
| LT AD (%) | | 87.2 | 87.2 | 86.9 |
| LT HT (%) | | 87.1 | 88.2 | 87.8 |
| Rs AD (Ω/m²) | | 6.8 | 7.0 | 6.8 |
| Rs HT (Ω/m²) | | 5.1 | 4.5 | 4.5 |
| Haze | | 5+ | 5 | 5 |

Each of the examples were measured before and after a heat treatment, referred to as AD and HT respectively. This heat treatment was designed to replicate the temperatures experienced during deposition of the CdS/CdTe device and consisted of placing each of the samples in a muffle furnace at 600 °C for approximately 5 minutes. The measured properties of each sample are defined as follows
- LT: This is the light transmission of the coating stack before and after heat treatment
- Rs: This is the sheet resistance of the coating stack before and after heat treatment
- Haze: This is a subjective visible haze scoring system that was applied to the Examples. The system using scores between 0 (perfect, no faults) up to 5 (dense haze, often already visible to the naked eye). 5+ refers to a particularly bad appearance.

The heat treatment was used to provide an indication as to how each of the samples would perform after high temperature processing. It is clear from Table 1 that none of the samples looked visually promising following this heat treatment, with Example 1 showing the worst visual damage. All samples did show a drop in sheet resistance however, which would be expected to be beneficial to the operation of a photovoltaic device.

(Detailed description of haze assessment - The evaluation system considers the more macroscopic effect of visible faults in the coating which cause local colour variations where the coating is damaged or imperfect. Macroscopic effects of visible faults in the coating after a heat treatment (all examples exhibit no haze before a heat treatment) were assessed subjectively by viewing samples under bright light. The evaluation is based upon a perfectness scoring (rating) system using scores between 0 (perfect, no faults) through to 3 (high number of clearly visible faults and/or spots) up to 5 (dense haze, often already visible to the naked eye), rating the visual appearance of the coated glass samples after a heat treatment. The visual evaluation was carried out by using a 2.5 million candle power beam (torch) that is directed at incidence angles between about -90° to about +90° (relative to normal incidence) in two orthogonal planes (i.e. turning the torch first in a horizontal plane and then in a vertical plane) onto a coated glass pane that is arranged in front of a black box. The black box has a sufficiently large size such that several coated glass samples can be evaluated at the same time. The coated glass panes are observed and their visual quality was assessed by varying the angle of incidence as described above, by directing the light beam from the observer through the coated glass panes. The coated glass panes were arranged in front of the black box such that their coating faced the observer. Heat treated coated glass panes with any score ≥ 3 are considered as having failed the test).

Each of examples 1 - 3 comprises:
- a substrate;
- a lower anti-reflection layer, comprising in sequence from the substrate
   ∘ a base layer of SiₓN_{y},
   ∘ a ZnSnOₓ layer,
   ∘ a TiO2 layer, and
   ∘ a top layer of ZnO:Al;
- a silver layer and
- a barrier layer, comprising in sequence from the silver layer
   ∘ a ZAO layer,
   ∘ a ZnSnOₓ layer and
   ∘ a ZAO layer.

In addition to the above, example 1 includes a ZnO:Al layer and example 2 includes a ZnSnOₓ layer and a ZnO:Al layer.

Subsequently a photovoltaic device comprising CdS/CdTe was deposited onto each of the stacks represented by examples 1-3, with maximum temperature during deposition and annealing being up to ∼600 °C. Approximate device structure was ∼120nm CdS and ∼2 µm CdTe, with gold being used as back contact.

Following device fabrication, characterisation of the solar cell was carried out, as will be familiar to those skilled in the art and results are shown in Table 2. For these measurements, the NSG **TEC**™ C15 sample was taken as the baseline and the results for the analyses of each of the Examples is shown relative to this.

Peak results and average results for a number of devices are shown.

**Table 2**

| | NSG TEC™ C15/ZnO:Al (25nm) | Example 1 | Example 2 | Example 3 (not according to the invention) |
|---|---|---|---|---|
| | SnO2 (25) | SixNy (26) | SixNy (27) | SixNy (30) |
| | SiO2 (25) | ZnSnOx (5) | ZnSnOx (5) | ZnSnOx (5) |
| | SnO2:F (340) | TiO2 (2.5) | TiO2 (2.5) | TiO2 (2.5) |
| | ZnO:Al (25) | ZnO:Al (5) | ZnO:Al (5) | ZnO:Al (5) |
| | | Ag (10) | Ag (10) | Ag (10) |
| | | ZAO (2) | ZAO (2) | ZAO (<5) |
| | | ZnSnOx (2) | ZnSnOx (2) | ZnSnOx (<5) |
| | | ZAO (3) | ZAO (3) | ZAO (44) |
| | | ZnO:Al (40) | ZnSnOx (26) | |
| | | | ZnO:Al (10) | |
| Peak Eff | 1.00 | 1.71 | 0.58 | 0.94 |
| Peak FF | 1.00 | 1.21 | 1.08 | 0.87 |
| Peak Jsc (mA/cm²) | 1.00 | 1.36 | 0.64 | 1.00 |
| Peak V_{OC} | 1.00 | 1.19 | 0.94 | 1.03 |
| Ave Eff | 1.00 | 2.07 | 0.73 | 1.93 |
| Ave FF (%) | 1.00 | 1.02 | 1.10 | 0.90 |
| Ave Jsc (mA/cm²) | 1.00 | 1.73 | 0.68 | 1.88 |
| Ave Voc (V) | 1.00 | 1.27 | 0.96 | 1.21 |

The V_{OC} value is increased significantly in example 1, indicating superior growth of CdS/CdTe on this stack. Efficiencies of devices deposited on this stack were also high compared to the baseline device. The excellent performance of Example 1 was surprising given its poor performance in the heat treatment tests described in Table 1.

Example 2, incorporating ZnSnOx in the upper AR layer, showed inferior performance to the other devices. However a working device was obtained and further optimisation of the device as detailed below could give improved performance.

Superior growth on ZnO:Al over ZAO is demonstrated but the ZAO device (example 3) shows superior performance over the NSG **TEC**™ C15 device which is significant in itself.

Also, the good performance of example 1 further surprised the inventors because according to their experience, a reactively sputtered ZnO:Al coating would have a very high resistivity - despite the teaching of FR2919114 referred to previously.

In order to investigate these resistivities further, four samples were prepared comprising samples of non-reactively sputtered ZAO and reactively sputtered ZnO:Al on both glass substrates and NSG TEC™ C15.

Theses samples are listed in table 3, along with measured and calculated electrical properties. Columns 3 - 5 respectively refer to the sheet resistance, thickness and resistivity of the top layer of ZAO or ZnO:Al as the case may be.

**Table 3**

| Sample | Description | Sheet Resistance (Ω/square) | Thickness (nm) | Resistivity (Ωcm) |
|---|---|---|---|---|
| 1 | ZAO on glass | 1393 | 83 | 1.16E-02 |
| 2 | ZAO on NSG TEC™ C15 | 485 | 83 | 4.03E-03 |
| 3 | ZnO:Al on glass | >1.00E+12 | 62 | >6.20E+06 |
| 4 | ZnO:Al on NSG TEC™ C15 | 520 | 62 | 3.22E-03 |

The data in table 3 accord with the inventors' expectation that reactively sputtered ZnO:Al has high resistivity hence its suitability as the top coating on a transparent electrode stack for a photovoltaic cell is all the more surprising.

It can be shown that the J_{SC} of the silver stacks could be improved further by use of a more optimised optical design. In the designs shown in Examples 1-3, an upper AR layer of ∼50nm was used, which is not optimal when a CdS layer is deposited on top of these due to increased reflection. Optical modelling results give the following:
- Non-optimised top AR layer (∼50nm) with 120nm CdS
   ∘ Solar transmittance = 33.52%
- Optimised top AR layer (∼120nm) with 120nm CdS
   ∘ Solar transmittance = 35.55%

This improvement in optical properties is shown by the measurement results below. Here a 120nm CdS layer is deposited on Example 1 with ∼50nm top AR layer and on a modified example 1 with 120nm top AR layer. The normalised transmission results when compared to a baseline TEC15/ZnO:Al are as follows:

| Layer | Normalised area under %T curve (400-900nm) |
|---|---|
| TEC15/ZnO:Al | 1.00 |
| 50nm top AR | 0.71 |
| 120nm top AR | 0.93 |

There is a clear improvement when a top AR layer of 120nm is used, which would be expected to produce an improvement in Jsc values.

For preferred embodiments of the invention, a top AR layer of between 110nm and 130nm is employed.

## Claims

1. A transparent electrode for a photovoltaic cell comprising the following sequence of layers:
a substrate;
a first dielectric layer, comprising in sequence from the substrate
∘ a base layer based on an (oxi)nitride of silicon and/or an (oxi)nitride of aluminium,
∘ a layer based on an oxide of Zn and Sn,
∘ a separation layer based on a metal oxide and/or an (oxi)nitride of silicon, and
∘ a top layer based on an oxide of Zn; and
a silver-based functional layer; and
wherein the electrode further comprises
a barrier layer; wherein the barrier layer comprises in sequence from the silver layer,
a ZAO layer;
a ZnSnOₓ layer; and
a ZAO layer; and wherein
each layer is located directly on the layer appearing immediately before it in the sequence, and wherein the electrode further comprises
a second dielectric layer on top of the barrier layer; wherein the second dielectric layer comprises
a layer of ZnO:Al.

2. An electrode according to claim 1, wherein the second dielectric layer further comprises a layer of ZnSnOₓ.

3. An electrode according to claim 2, wherein the layer of ZnSnOₓ is located between the barrier layer and the ZnO:Al layer.

4. An electrode according to any of claims 1 - 3, wherein the base layer based on an (oxi) nitride of silicon and/or an (oxi) nitride of aluminium has a thickness of from 20 to 40 nm.

5. An electrode according to any of claims 1 - 4, wherein the layer based on an oxide of Zn and Sn of the first dielectric layer has a thickness of from 1 to 8 nm.

6. An electrode according to any preceding claim, wherein the layer based on an oxide of Zn and Sn of the first dielectric layer is located directly on the base layer based on an (oxi) nitride of silicon and/or an (oxi) nitride of aluminium.

7. An electrode according to any preceding claim, wherein the separation layer based on a metal oxide and/or an (oxi)nitride of silicon has a thickness of from 0.5 to 5 nm.

8. An electrode according to any preceding claim, wherein when the separation layer is based on a metal oxide said separation layer comprises a layer of an oxide of Ti, NiCr, InSn, Zr, Al and/or Si.

9. An electrode according to any preceding claim, wherein the separation layer further includes one or more other chemical elements chosen from at least one of the following elements Ti, V, Mn, Co, Cu, Zn, Zr, Hf, Al, Nb, Ni, Cr, Mo, Ta, or from an alloy based on at least one of these materials.

10. An electrode according to any preceding claim, wherein the top layer based on an oxide of Zn has a thickness of from 3 to 10 nm.

11. An electrode according to any preceding claim, wherein the silver-based functional layer has a thickness of from 5 to 13 nm.

12. An electrode according to any preceding claim, wherein the top layer based on an oxide of Zn in the first dielectric layer is in direct contact with the silver-based functional layer.

13. An electrode according to any preceding claim, wherein the barrier layer has a thickness of from 1 to 10 nm.

14. An electrode according to claim 1, 2 or 3 comprising:
- a substrate;
- a first dielectric layer, comprising in sequence from the substrate
∘ a base layer of SiₓN_{y},
∘ a ZnSnOₓ layer,
∘ a TiO₂ layer, and
∘ a top layer of ZnO:Al;
- a silver layer and
- a barrier layer, comprising in sequence from the silver layer
∘ a ZAO layer,
∘ a ZnSnOₓ layer and
∘ a ZAO layer.

15. An electrode according to any preceding claim, where the second dielectric layer is less than 130nm thick.

16. An electrode according to claim 15, where the second dielectric layer is greater than 110nm thick.

17. A photovoltaic cell comprising an electrode according to any preceding claim.

## Patentansprüche

1. Transparente Elektrode für eine photovoltaische Zelle mit der folgenden Abfolge von Schichten
ein Substrat;
eine erste dielektrische Schicht, die der Reihe nach, vom Substrat aus, umfasst:
• eine Basisschicht auf Grundlage eines (Oxi)Nitrids von Silizium und/oder eines (Oxi)Nitrids von Aluminium,
• eine Schicht auf Grundlage eines Oxids von Zn und Sn,
• eine Trennschicht auf Grundlage eines Metalloxids und/oder eines (Oxi)Nitrids von Silizium, und
• eine Deckschicht auf Grundlage eines Oxids von Zn; und eine Funktionsschicht auf Silbergrundlage; und
wobei die Elektrode ferner umfasst:
eine Sperrschicht, wobei die Sperrschicht der Reihe nach, von der Silberschicht aus, umfasst
eine ZAO-Schicht
eine ZnSnOₓ-Schicht; und
eine ZAO-Schicht; und wobei
jede Schicht direkt auf der Schicht angeordnet ist, die in der Reihenfolge unmittelbar vor ihr erscheint, und wobei die Elektrode ferner eine zweite dielektrische Schicht auf der Sperrschicht umfasst; wobei die zweite dielektrische Schicht eine Schicht aus ZnO:Al umfasst.

2. Elektrode nach Anspruch 1, bei der die zweite dielektrische Schicht ferner eine Schicht aus ZnSnOₓ umfasst.

3. Elektrode nach Anspruch 2, bei der sich die Schicht aus ZnSnOₓ zwischen der Sperrschicht und der ZnO:Al-Schicht befindet.

4. Elektrode nach einem der Ansprüche 1 bis 3, bei der die Basisschicht auf Grundlage eines (Oxi)Nitrids von Silizium und/oder eines (Oxi)Nitrids von Aluminium eine Dicke von 20 bis 40 nm aufweist.

5. Elektrode nach einem der Ansprüche 1 bis 4, bei der die Schicht auf Grundlage eines Oxids von Zn und Sn der ersten dielektrischen Schicht eine Dicke von 1 bis 8 nm aufweist.

6. Elektrode nach einem der vorhergehenden Ansprüche, bei der die Schicht auf Grundlage eines Oxids von Zn und Sn der ersten dielektrischen Schicht direkt auf der Basisschicht auf Grundlage eines (Oxi)Nitrids von Silizium und/oder eines (Oxi)Nitrids von Aluminium angeordnet ist.

7. Elektrode nach einem der vorhergehenden Ansprüche, bei der die Trennschicht auf Grundlage eines Metalloxids und/oder eines (Oxi)Nitrids von Silizium eine Dicke von 0,5 bis 5 nm aufweist.

8. Elektrode nach einem der vorhergehenden Ansprüche, bei der die Trennschicht auf einem Metalloxid basiert, und die Trennschicht eine Schicht aus einem Oxid von Ti, NiCr, InSn, Zr, Al und/oder Si umfasst.

9. Elektrode nach einem der vorhergehenden Ansprüche, bei der die Trennschicht ferner ein oder mehrere andere chemische Elemente enthält, die aus mindestens einem der folgenden Elemente Ti, V, Mn, Co, Cu, Zn, Zr, Hf, Al, Nb, Ni, Cr, Mo, Ta oder aus einer Legierung auf Grundlage von mindestens einem dieser Materialien ausgewählt sind.

10. Elektrode nach einem der vorhergehenden Ansprüche, **dadurch gekennzeichnet, dass** die Deckschicht auf der Grundlage eines Oxids von Zn eine Dicke von 3 bis 10 nm aufweist.

11. Elektrode nach einem der vorhergehenden Ansprüche, bei der die Funktionsschicht auf Silbergrundlage eine Dicke von 5 bis 13 nm aufweist.

12. Elektrode nach einem der vorhergehenden Ansprüche, bei der die Deckschicht auf Grundlage eines Oxids von Zn in der ersten dielektrischen Schicht in direktem Kontakt mit der Funktionsschicht auf Silbergrundlage steht.

13. Elektrode nach einem der vorhergehenden Ansprüche, bei der die Sperrschicht eine Dicke von 1 bis 10 nm aufweist.

14. Elektrode nach Anspruch 1, 2 oder 3, umfassend:
- ein Substrat;
- eine erste dielektrische Schicht, die der Reihe nach, vom Substrat aus, umfasst:
• eine Basisschicht aus SiₓN_{y},
• eine ZnSnOₓ-Schicht,
• eine TiO2-Schicht, und
• eine Deckschicht aus ZnO:Al;
- eine Silberschicht und
- eine Sperrschicht, die der Reihe nach, von der Silberschicht aus, umfasst:
• eine ZAO-Schicht,
• eine ZnSnOₓ-Schicht und
• eine ZAO-Schicht.

15. Elektrode nach einem der vorhergehenden Ansprüche, bei der die zweite dielektrische Schicht weniger als 130nm dick ist.

16. Elektrode nach Anspruch 15, bei der die zweite dielektrische Schicht eine Dicke von mehr als 110 nm aufweist.

17. Photovoltaische Zelle mit einer Elektrode nach einem der vorhergehenden Ansprüche.

## Revendications

1. Electrode transparente pour une pile photovoltaïque comprenant la succession suivante de couches :
un substrat ;
une première couche électrique, comprenant successivement à partir du substrat
∘ une couche de base basée sur un (oxy)nitrure de silicium et/ou un (oxy)nitrure d'aluminium,
∘ une couche basée sur un oxyde de Zn et Sn,
∘ une couche de séparation basée sur un oxyde de métal et/ou un (oxy)nitrure de silicium, et
∘ une couche supérieure basée sur un oxyde de Zn ; et
une couche fonctionnelle à base d'argent ; et
dans laquelle l'électrode comprend de plus
une couche barrière ; dans laquelle la couche barrière comprend successivement à partir de la couche d'argent,
une couche de ZAO ;
une couche de ZnSnOₓ ; et
une couche de ZAO ; et dans laquelle
chaque couche est située directement sur la couche apparaissant immédiatement avant elle dans la succession, et dans laquelle l'électrode comprend de plus
une seconde couche diélectrique sur le haut de la couche barrière ; dans laquelle la seconde couche diélectrique comprend
une couche de ZnO:Al.

2. Electrode selon la revendication 1, dans laquelle la seconde couche diélectrique comprend de plus une couche de ZnSnOₓ.

3. Electrode selon la revendication 2, dans laquelle la couche de ZnSnOₓ est située entre la couche barrière et la couche de ZnO:Al.

4. Electrode selon l'une quelconque des revendications 1-3, dans laquelle la couche de base basée sur un (oxy)nitrure de silicium et/ou un (oxy)nitrure d'aluminium présente une épaisseur de 20 à 40 nm.

5. Electrode selon l'une quelconque des revendications 1-4, dans laquelle la couche basée sur un oxyde de Zn et Sn de la première couche diélectrique présente une épaisseur de 1 à 8 nm.

6. Electrode selon l'une quelconque des revendications précédentes, dans laquelle la couche basée sur un oxyde de Zn et Sn de la première couche diélectrique est située directement sur la couche de base basée sur un (oxy)nitrure de silicium et/ou un (oxy)nitrure d'aluminium.

7. Electrode selon l'une quelconque des revendications précédentes, dans laquelle la couche de séparation basée sur un oxyde de métal et/ou un (oxy)nitrure de silicium présente une épaisseur de 0,5 à 5 nm.

8. Electrode selon l'une quelconque des revendications précédentes, dans laquelle lorsque la couche de séparation est basée sur un oxyde de métal, ladite couche de séparation comprend une couche d'un oxyde de Ti, NiCr, InSn, Zr, Al et/ou Si.

9. Electrode selon l'une quelconque des revendications précédentes, dans laquelle la couche de séparation inclut de plus un ou plusieurs autres éléments chimiques choisis parmi au moins un des éléments suivants Ti, V, Mn, Co, Cu, Zn, Zr, Hf, Al, Nb, Ni, Cr, Mo, Ta, ou parmi un alliage basé sur au moins un de ces matériaux.

10. Electrode selon l'une quelconque des revendications précédentes, dans laquelle la couche supérieure basée sur un oxyde de Zn présente une épaisseur de 3 à 10 nm.

11. Electrode selon l'une quelconque des revendications précédentes, dans laquelle la couche fonctionnelle à base d'argent présente une épaisseur de 5 à 13 nm.

12. Electrode selon l'une quelconque des revendications précédentes, dans laquelle la couche supérieure basée sur un oxyde de Zn dans la première couche diélectrique est en contact directe avec la couche fonctionnelle à base d'argent.

13. Electrode selon l'une quelconque des revendications précédentes, dans laquelle la couche barrière présente une épaisseur de 1 à 10 nm.

14. Electrode selon la revendication 1, 2 ou 3 comprenant :
- un substrat ;
- une première couche diélectrique, comprenant successivement à partir du substrat
∘ une couche de base de SiₓN_{y},
∘ une couche de ZnSnOₓ,
∘ une couche de TiO₂, et
∘ une couche supérieure de ZnO:Al ;
- une couche d'argent et
- une couche barrière, comprenant successivement à partir de la couche d'argent
∘ une couche de ZAO,
∘ une couche de ZnSnOₓ et
∘ une couche de ZaO.

15. Electrode selon l'une quelconque des revendications précédentes, où la seconde couche diélectrique est d'une épaisseur inférieure à 130 nm.

16. Electrode selon la revendication 15, où la seconde couche diélectrique est d'une épaisseur supérieure à 110 nm.

17. Pile photovoltaïque comprenant une électrode selon l'une quelconque des revendications précédentes.
